Europäisches Patentamt

European Patent Office

Office européen des brevets

(19)

(11) Veröffentlichungsnummer: **0 657 740 A2**

## (12) EUROPÄISCHE PATENTANMELDUNG

(21) Anmeldenummer: **94118299.0**

(22) Anmeldetag: **21.11.94**

(51) Int. Cl.6: **G01R 15/24**

(30) Priorität: **13.12.93 DE 4342410**

(43) Veröffentlichungstag der Anmeldung:
**14.06.95 Patentblatt 95/24**

(84) Benannte Vertragsstaaten:
**DE FR GB SE**

(71) Anmelder: **ABB RESEARCH LTD.**
**Affolternstrasse 52**
**CH-8050 Zürich 11 (CH)**

(72) Erfinder: **Meier, Markus, Dr.**
**Fröhlichstrasse 5**
**CH-5000 Aarau (CH)**

(74) Vertreter: **Rzehak, Herbert et al**
**c/o ABB Management AG,**
**Abt. TEI-Immaterialgüterrecht**
**CH-5401 Baden (CH)**

(54) **Verfahren zur magnetooptischen Strommessung und magnetooptische Strommesseinrichtung.**

(57) Es werden einfache Verfahren zur magnetooptischen Strommessung und magnetooptische Strommeßeinrichtungen angegeben, die unabhängig von Temperatureinflüssen auf das Meßergebnis sind und keine Kompensationseinrichtung für die Lichtstärke von verwendeten Lichtquellen (LD1, LD2) erfordern. Von den beiden Laser-Lichtquellen (LD1, LD2) werden alternierend Lichtstrahlen (1, 2) mittels eines Strahlteilers (3) orthogonal zueinander polarisiert und über Kollimatoren (4, 6), welche über eine polarisationserhaltende hochdoppelbrechende HB-Faser (5) verbunden sind, durch einen magnetooptischen Stromsensor (7), einen Analysator (10), 2 Kollimatoren (11, 12) sowie Multimodefasern (13) und (14) zu Lichtdetektoren ($D_A$, $D_B$) übertragen. Zeitlich nacheinander werden von den Lichtdetektoren ($D_A$, $D_B$) 1. und 2. Lichtleistungssignale $S_{A1}$ bzw. $S_{B1}$ sowie 3. und 4. Lichtleistungssignale $S_{A2}$ bzw. $S_{B2}$ abgeleitet. Mit einem Funktionsbildner (22) einer Steuer- und Auswerteinrichtung (15) wird eine mittels des magnetooptischen Stromsensors (7) erfaßte Stromstärke I gemäß: $I = [S_{A1} \cdot S_{B2}/(S_{A2} \cdot S_{B1}) - 1]/(8 \cdot V)$ berechnet, wobei V die magnetooptische Verdet-Konstante ist. Statt zeitmultiplex kann auch frequenzmultiplex gearbeitet werden. Statt eines massivoptischen Stromsensors (7) kann eine niedrigdoppelbrechende LB-Faser verwendet werden, wobei Licht in beiden Richtungen hindurchgeschickt und separat ausgewertet wird.

Fig. 1

EP 0 657 740 A2

TECHNISCHES GEBIET

Bei der Erfindung wird ausgegangen von einem Verfahren zur magnetooptischen Strommessung und von einer magnetooptischen Strommeßeinrichtung nach dem Oberbegriff der Patentansprüche 1, 2, 6 und 7.

STAND DER TECHNIK

Mit dem Oberbegriff der Patentansprüche 1, 2, 6 und 7 nimmt die Erfindung auf einen Stand der Technik Bezug, wie er aus der EP-B1-0 254 396 bekannt ist. Dort wird ein Verfahren zur Driftkompensation bei einem optomagnetischen Strommesser für Gleichstrom beschrieben, bei dem Licht gleicher Wellenlänge aus 2 Laserdioden über einen Polarisator durch einen optomagnetischen Sensor geleitet, danach durch einen Analysator geschickt und mittels 2er Photodetektoren detektiert sowie in elektrische Signale a und b umgewandelt wird. Polarisator und Analysator liefern ausgangsseitig jeweils 2 rechtwinklig zueinander polarisierte Ausgangsstrahlen, wobei der Analysator gegenüber dem Polarisator um 45° hinsichtlich der Polarisationsebenen gedreht ist. Die rechtwinklig zueinander polarisierten Lichtstrahlen aus dem Polarisator treten abwechselnd durch den optomagnetischen Sensor, so daß 1. und 2. Ausgangssignale $a_1$, $a_2$ und $b_1$, $b_2$ detektiert werden. Die Intensitäten der Eingangslichtstrahlen werden so eingestellt, daß $(a + b)_1 = (a + b)_2$ ist und die Verstärkung in den Auswertkanälen so, daß
$(a - b)_1 + (a - b)_2 = 0$ ist. Der Wert $(a - b)_1 - (a - b)_2$ wird als Ausgangssignal geliefert, welcher proportional zum Strom ist. Dieses von Koppler- und Modulatoreinflüssen unabhängige Verfahren zur Strommessung ist relativ aufwendig. Für genaue Gleichstromwandler müssen die verwendeten Strahlteiler eine Stabilität des Teilverhältnisses von etwa 10 ppm über den ganzen Temperaturbereich aufweisen.

Durch den Konferenzbericht von Kiyoshi Kurosawa, A METHOD WITH TWO SOURCES FOR ACCURATE D. C. CURRENT MEASUREMENT USING FARADAY EFFECT, 9th Optical Fiber Sensors Conference, Florenz, 4. - 6. 5. 1993, S. 439 - 442, ist es bekannt, zur Erreichung einer hohen Meßgenauigkeit bei einer Meßanordnung gemäß der o. g. EP-B1-0 254 396 zwei Lichtquellen unterschiedlicher Wellenlänge zu verwenden und das Verhältnis $(a_1/a_2)/(b_2/b_1)$ als Ausgangssignal zur Berechnung des Stromes zu bilden. Dabei müssen die spektralen Empfindlichkeiten der Kanäle über die Zeit und Temperatur stabil sein. Die verwendeten Multimode-Fasern stellen größere Anforderungen an die Lichtquellen.

DARSTELLUNG DER ERFINDUNG

Die Erfindung, wie sie in den Patentansprüchen 1, 2, 6 und 7 definiert ist, löst die Aufgabe, ein Verfahren zur magnetooptischen Strommessung und eine magnetooptische Strommeßeinrichtung der eingangs genannten Art derart weiterzuentwikkeln, daß eine von Temperatureinflüssen unabhängige Strommessung mit geringem Aufwand sowohl für Gleich- als auch für Wechselstrom möglich ist.

Ein Vorteil der Erfindung besteht darin, daß keine Kompensationseinrichtung für die Lichtstärke der Lichtquellen erforderlich ist.

KURZE BESCHREIBUNG DER ZEICHNUNGEN

Die Erfindung wird nachstehend anhand von Ausführungsbeispielen erläutert. Es Zeigen:

| | |
|---|---|
| Fig. 1 | eine magnetooptische Strommeßeinrichtung mit einem massivoptischen Faraday-Rotator als magnetooptischem Stromsensor und mit alternierendem Betrieb der Lichtquellen, |
| Fig. 2a - 2d | Signaldiagramme von Ein- und Ausgangssignalen der magnetooptischen Strommeßeinrichtung gemäß Fig. 1, |
| Fig. 3 | eine magnetooptische Strommeßeinrichtung mit Frequenzmultiplex-Betrieb, |
| Fig. 4 | eine Prinzipdarstellung der Drehung der Polarisationsrichtung des Lichtes durch den magnetooptischen Effekt des zu messenden elektrischen Stromes und |
| Fig. 5 und 6 | magnetooptische Strommeßeinrichtungen mit niedrigdoppelbrechenden optischen LB-Fasern als magnetooptischen Stromsensoren und mit integriert optischem Chip. |

WEGE ZUR AUSFÜHRUNG DER ERFINDUNG

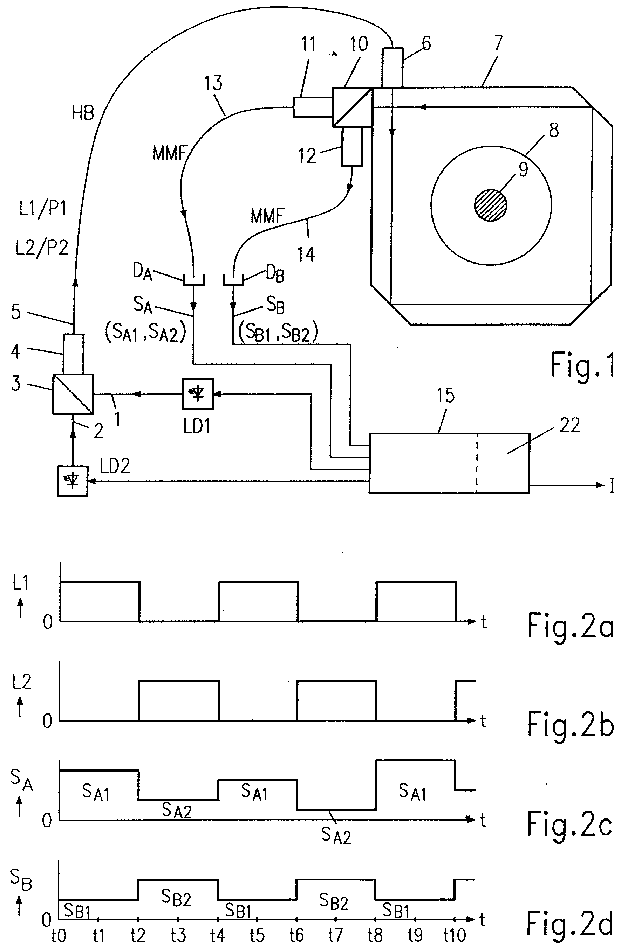

Die magnetooptische Strommeßeinrichtung gemäß Fig. 1 zeigt Laserdioden (LD1) und (LD2), die alternierend, vgl. die Fig. 2a und 2b, Lichtstrahlen (1) bzw. (2) über einen Polarisator oder polarisierenden Strahlteiler (3), eine Gradientenindex-Linse bzw. einen Kollimator (4), eine hochdoppelbrechende, polarisationserhaltende optische Faser bzw. HB-Faser (5) und einen weiteren Kollimator (6) durch einen magnetooptischen Stromsensor (7), einen polarisierenden Strahlteiler bzw. Analysator (10), 2 daran angeschlossene Kollimatoren (11) und (12) und von diesen über optische Multimode- bzw.

MM-Fasern (13) und (14) zu Photodioden bzw. Lichtdetektoren ($D_A$, $D_B$) senden. Proportional zur empfangenen Lichtintensität werden von den Lichtdetektoren ($D_A$, $D_B$) elektrische Ausgangssignale ($S_A$, $S_B$) erzeugt und an eine Steuer- und Auswerteinrichtung (15) übertragen. Der magnetooptische Stromsensor (7) aus Quarz oder einem anderen transparenten Werkstoff weist mehrere spiegelnde Seitenflächen, in seinem Inneren eine Aussparung (8) und darin einen Stromleiter (9) auf.

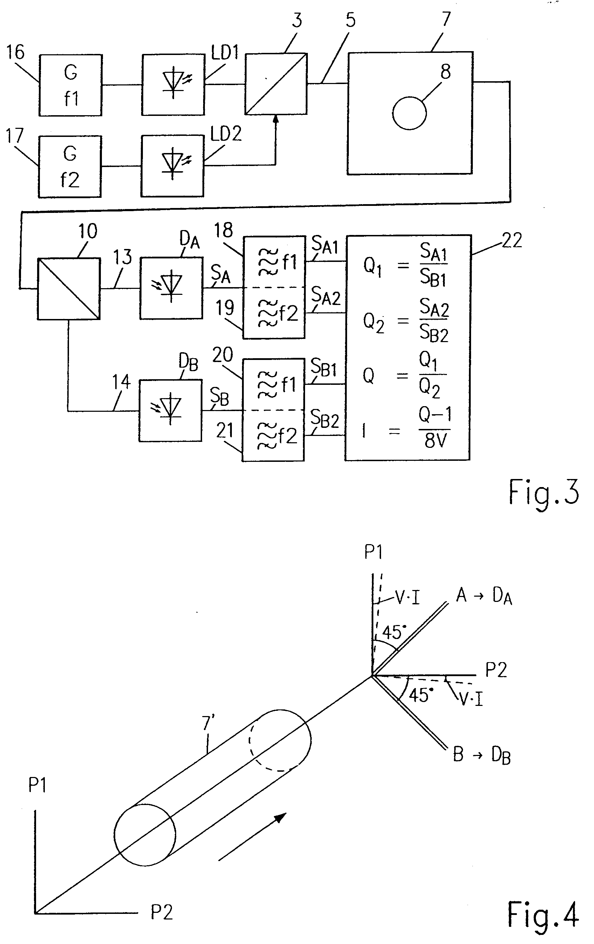

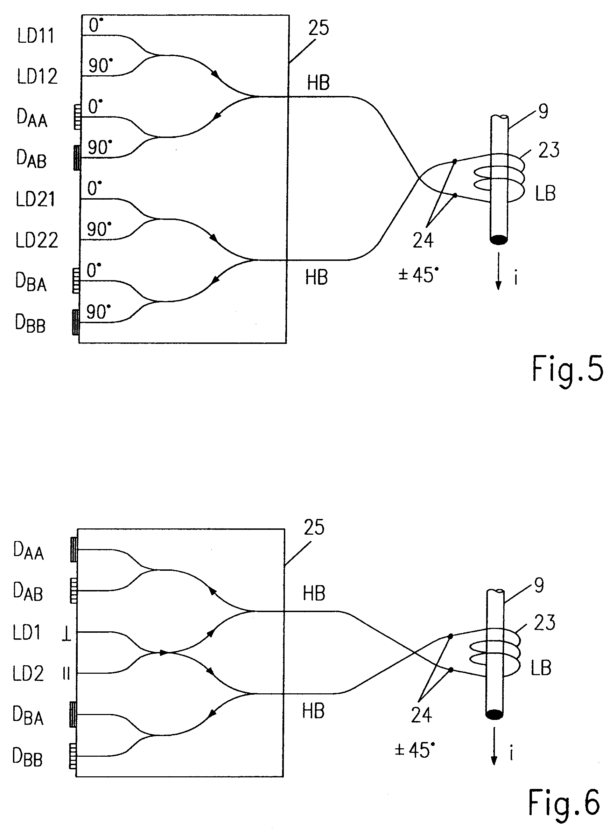

Die Stromstärke (I) eines elektrischen Stromes (i), vgl. die Fig. 5 und 6, durch den Stromleiter (9) wird mittels des magnetooptischen Stromsensors (7) durch die Wirkung des magnetooptischen bzw. Faraday-Effektes erfaßt und von einer Auswerteinrichtung bzw. einem näher in Fig. 3 gezeigten Funktionsbildner (22) der Steuer- und Auswerteinrichtung (15) berechnet und ausgegeben oder anderen, nicht dargestellten Einrichtungen zur Verfügung gestellt.

Die Steuer- und Auswerteinrichtung (15) schaltet alternierend die Lichtquellen (LD1, LD2) ein, so daß durch die HB-Faser (5) nacheinander polarisierte Lichtstrahlen bzw. Eingangslichtstrahlen (L1) mit einer 1. Polarisationsrichtung (P1) von der Lichtquelle (LD1) in Zeitabschnitten zwischen Zeitpunkten (t0) und (t2), zwischen (t4) und (t6), zwischen (t8) und (t10) usw., vgl. Fig. 2a, und Eingangslichtstrahlen (L2) mit einer 2. Polarisationsrichtung (P2) von der Lichtquelle (LD2) in Zeitabschnitten zwischen Zeitpunkten (t2) und (t4), zwischen (t6) und (t8) usw., vgl. Fig. 2b, übertragen werden. Der Strahlteiler (3) liefert ausgangsseitig Eingangslichtstrahlen (L1, L2) für den magnetooptischen Stromsensor (7) mit rechtwinklig zueinander orientierten Polarisationsrichtungen (P1, P2), vgl. Fig. 4. Die Polarisation des einen Lasers (LD1) wird auf eine Achse der HB-Faser (5), diejenige des anderen Lasers (LD2) auf die andere orthogonale Achse der HB-Faser (5) orientiert, wobei der Kollimator (4) das Licht der Laserdioden (LD1) und (LD2) in die HB-Faser (5) einkoppelt. Damit wird das Licht dieser beiden Lichtquellen (LD1, LD2) polarisationserhaltend durch die HB-Faser (5) transportiert. Am Ende der HB-Faser (5) befindet sich der diskret aufgebaute oder als sog. SELFOC-Linse realisierte Kollimator (6), welcher das Licht (L1, L2) kollimiert. Es tritt dann in den magnetooptischen Stromsensor (7) ein, in dem es einmal oder vorzugsweise mehrmals umläuft. Dort wird die Polarisationsebene durch die Wirkung des Magnetfeldes des elektrischen Stromes (i) um einen zum Strom (i) proportionalen Winkel V • I gedreht, wobei V die magnetooptische bzw. Verdet-Konstante, gemessen in rad/A, und I die Stromstärke des Stromes (i), gemessen in A, bedeuten. Am Ausgang des magnetooptischen Stromsensors (7) wird das Licht über den 2. polarisierenden Strahlteiler (10) und die 2 Kollimatoren (11, 12) auf die 2 MM-Fasern (13) und (14) fokussiert. Der Strahlteiler (10) spaltet das Licht in 2 rechtwinklig zueinander orientierte 3. und 4. Polarisationsrichtungen (A, B) auf, die ohne Strom (i), gegenüber den beiden Polarisationsrichtungen (P1, P2) des 1. Strahlteilers (3) um 45° gedreht sind, vgl. Fig. 4. Anstelle des polarisierenden Strahlteilers (10) kann ein geometrischer Strahlteiler mit nachfolgenden Polarisatoren verwendet werden. Die MM-Fasern (13) und (14) transportieren das Licht zu den 2 entfernt angeordneten Lichtdetektoren ($D_A$, $D_B$), welche proportional zur Lichtintensität die elektrischen Ausgangssignale ($S_A$, $S_B$) erzeugen. Diese werden dann durch die nachfolgende Steuer- und Auswerteinrichtung (15) verarbeitet.

Das Licht, das aus der HB-Faser (5) austritt, teilt sich nach dem magnetooptischen Stromsensor (7) auf die beiden Polarisationskanäle (A, B) auf. Für die nachfolgende Rechnung ist angenommen, daß die Aufspaltung für beide Polarisationsrichtungen (P1) und (P2) gleich ist. Diese Annahme ist berechtigt, da beide Polarisationen aus derselben HB-Faser (5) austreten und den gleichen Weg durch den Glasblock (7) und die nachfolgende Strahlaufteilung nehmen.

Die beiden Lichtquellen (LD1, LD2) werden abwechselnd ein- und ausgeschaltet. Während einer 1. Phase in den Zeitintervallen (t0) bis (t2), (t4) bis (t6), (t8) bis (t10) usw., in welcher der 1. Laser (LD1) ein- und der 2. Laser (LD2) ausgeschaltet sind, mißt man mit den beiden Lichtdetektoren ($D_A$, $D_B$) folgende Ausgangssignale $S_{A1}$, $S_{B1}$, vgl. Fig. 2c und 2d:

$$S_{A1} = I_1 \cdot a \cdot D_a \cdot 0{,}5 \cdot (1 + \sin(2 \cdot V \cdot I)) \text{ und}$$
$$S_{B1} = I_1 \cdot b \cdot D_b \cdot 0{,}5 \cdot (1 - \sin(2 \cdot V \cdot I)).$$

Während einer 2. Phase in den Zeitintervallen (t2) bis (t4), (t6) bis (t8) usw., in welcher der 1. Laser (LD1) aus- und der 2. Laser (LD2) eingeschaltet sind, mißt man mit den beiden Lichtdetektoren ($D_A$, $D_B$) folgende Ausgangssignale $S_{A2}$, $S_{B2}$, vgl. Fig. 2c und 2d:

$$S_{A2} = I_2 \cdot a \cdot D_a \cdot 0{,}5 \cdot (1 - \sin(2 \cdot V \cdot I)) \text{ und}$$
$$S_{B2} = I_2 \cdot b \cdot D_b \cdot 0{,}5 \cdot (1 + \sin(2 \cdot V \cdot I)).$$

Dabei bedeuten: $I_1$ und $I_2$ die Intensitäten der Lichtquellen (LD1) bzw. (LD2), a und b die Transmissionsfaktoren in den Polarisationskanälen (A) bzw. (B) sowie $D_a$ und $D_b$ die Empfindlichkeiten der Lichtdetektoren ($D_A$) bzw. ($D_B$) in den Kanälen (A) bzw. (B), einschließlich der Verstärkung in der Elektronik der Steuer- und Auswerteinrichtung (15) und/oder eines nicht dargestellten Analog/Digital-Wandlers.

Man bildet nun die folgenden Quotienten:

$Q1 = S_{A1}/S_{B1} \approx (1 + 4 \cdot V \cdot I) \cdot a \cdot D_a/(b \cdot D_b),$
$Q2 = S_{A2}/S_{B2} \approx (1 - 4 \cdot V \cdot I) \cdot a \cdot D_a/(b \cdot D_b)$
und daraus
$Q \approx Q1/Q2 = 1 + 8 \cdot V \cdot I.$

Daraus ergibt sich die Stromstärke (I) zu:

$I = (Q - 1)/(8 \cdot V).$

Die so gewonnenen Größen Q und I sind unabhängig von den beiden Laserintensitäten ($I_1$) und ($I_2$), von dem unbekannten Aufspaltverhältnis (a/b) und vom Verhältnis der Diodenempfindlichkeiten ($D_a/D_b$). Eine Drift in allen diesen Größen stört das Meßergebnis nicht.

Die Datenauswertung muß so erfolgen, daß die Ausgangssignale ($S_{A1}$, $S_{A2}$, $S_{B1}$, $S_{B2}$) der Lichtdetektoren ($D_A$, $D_B$) zu den entsprechenden Zeiten (t1, t3, t5, t7, t9), vgl. Fig. 2d, gemessen werden und die Quotientenbildung anschließend erfolgt. Dazu bietet sich die digitale Signalverarbeitung mit einem Mikro- oder Signalprozessor an. Die Schalt- und Abtastfrequenz sollte groß gegenüber der höchsten Signalfrequenz des zu messenden Stromsignals (I) gewählt werden. Die Meßgenauigkeit hängt von der Genauigkeit der A/D-Wandler ab. Diese müssen eine genügende Linearität und Auflösung aufweisen. Eine sehr hohe Genauigkeit oder eine Symmetrie zwischen den beiden Polarisationskanälen (A, B) ist jedoch nicht erforderlich.

Die obige Gleichung für Q gilt näherungsweise; ihr liegt vereinfachend eine Linearisierung zugrunde, die für kleine Werte der Faradaydrehung und die Ruhelage der Polarisation bei 45° gilt. Eine genaue Berechnung liefert: $Q = Q1/Q2 = [1 + \sin(2 \cdot V \cdot I)]^2/[1 - \sin(2 \cdot V \cdot I)]^2$ und somit

$I = \{\arg \sin [(Q^{0,5} - 1)/(Q^{0,5} + 1)]\}/(2 \cdot V).$

Fig. 3 zeigt eine magnetooptische Strommeßeinrichtung, bei der die Strommessung nicht im Zeitmultiplex-Verfahren, wie gemäß den Fig. 1 und 2, sondern im Frequenzmultiplex-Verfahren durchgeführt wird. Gleiche Bauelemente sind gleich bezeichnet.

Die beiden Laser (LD1, LD2) mit den orthogonalen Polarisationsrichtungen (P1, P2) werden durch 2 Frequenzgeneratoren (16, 17) mit 2 verschiedenen Frequenzen (f1, f2) in der Intensität moduliert. Das aus dem magnetooptischen Stromsensor (7) austretende Licht wird in einem polarisierenden Strahlteiler (10) aufgespalten und mit Multimodefasern (13, 14) den beiden Lichtdetektoren ($D_A$) und ($D_B$) zugeführt. Die Ausgangssignale $S_A = S_{A1} + S_{A2}$ und $S_B = S_{B1} + S_{B2}$ der Lichtdetektoren ($D_A$, $D_B$) für die beiden Polarisationsrichtungen (A, B) werden in nachfolgenden Bandpaßfiltern (18 - 21) anhand der unterschiedlichen Frequenzen (f1, f2) in die Ausgangssignale ($S_{A1}$, $S_{A2}$, $S_{B1}$, $S_{B2}$) getrennt. Die Berechnung der Quotienten Q1, Q2 und Q sowie der Stromstärke I erfolgt in einer Auswerteinrichtung bzw. einem Rechner oder Funktionsbildner (22). Die Filterung und Quotientenbildung kann sowohl analog als auch digital erfolgen. Die Modulationsfrequenzen müssen deutlich höher liegen als die höchste Signalfrequenz des zu messenden Stromes (i).

Fig. 4 zeigt schematisch die Gleichstrommessung mit orthogonalen Polarisatoren, wobei mit (7') ein Faraday-Rotator bezeichnet ist. Der Pfeil deutet die Durchgangsrichtung des Lichtes an.

Bei den Ausführungsbeispielen gemäß den Fig. 5 und 6 wird als magnetooptischer Stromsensor eine gedrehte niedrigdoppelbrechende Faser bzw. LB-Faser (23) oder eine gesponnene HB-Faser mit großer zirkularer Doppelbrechung verwendet. Da in diesen Fasern temperaturabhängige Drehungen der Polarisationsebene vorkommen, muß eine Messung in beiden Richtungen der Faser vorgenommen werden, um mit Hilfe des nichtreziproken Faraday-Effektes den Temperatureffekt vom Faraday-Effekt trennen zu können. Für die Zusammenführung und Trennung der optischen Signale wird hier als Ein-/Ausgabemodul eine integriert-optische Mikroschaltung bzw. ein IO-Chip (25) verwendet, bei dem durch einen Diffusionsprozeß monomodige Wellenleiterstrukturen in Glas erzeugt worden sind.

Bei dem Ausführungsbeispiel gemäß Fig. 5 wird Licht von 2 orthogonal zueinander polarisierten Laserdioden (LD11, LD12) in den IO-Chip (25) eingekoppelt und über 2 Verzweiger, eine HB-Faser und einen Faserspleiß bzw. Faserkoppler (24) in die LB-Faser (23) eingekoppelt. Durch den Faraday-Effekt wird in der LB-Faser (23) die Polarisationsebene des Lichtes proportional zum elektrischen Strom (i) gedreht. Im Falle eines stromlosen Zustandes tritt das Licht am Ende der LB-Faser (23) über einen Faserkoppler (24) unter 45° zu den Achsen einer weiteren HB-Faser linear polarisiert aus. Von da wird es zum IO-Chip (25) zurückgeführt. Dort wird es über 2 Strahlteiler und unter 0° bzw. 90° stehende Analysatoren, die am linken Rand des IO-Chips (25) angedeutet sind, zu Lichtdetektoren ($D_{BA}$, $D_{BB}$) geleitet. In völlig analoger Weise findet die Messung in die andere Richtung der LB-Faser (23) mit orthogonal zueinander polarisierten Laserdioden (LD21, LD22) und Lichtdetektoren ($D_{AA}$, $D_{AB}$) statt. Die Steuerung der Laserdioden (LD11, LD12, LD21, LD22) findet in einer Elektronikeinheit analog zu der Steuer- und Auswerteinrichtung (15) von Fig. 1 statt. Der IO-Chip (25) kann doppelbrechend sein. Vorteilhafterweise werden die Achsen der HB-Faser zu den Achsen des IO-Chips (25) orientiert. Es können billige Polarisatoren verwendet werden.

Fig. 6 zeigt eine Ausführung, bei der die beiden Lichtquellen (LD1, LD2) in beiden Richtungen der LB-Faser (23) verwendet werden. Das Licht dieser beiden Laserdioden (LD1, LD2) wird im IO-Chip (25) zuerst in einem Strahlteiler vereint und danach wieder aufgeteilt, um über die beiden Faserkoppler (24) in die LB-Faser (23) eingekoppelt zu werden. Detektion und Auswertung erfolgen analog zum Ausführungsbeispiel gemäß Fig. 5. Bei diesem Ausführungsbeispiel kann es Streulichtprobleme geben, da das Licht einer Lichtquelle nicht nur den zur Strommessung gewünschten Weg über die Sensorfaser zum Detektor nehmen, sondern als Streulicht an den Strahlteilern auch als Störsignal auf die Detektoren gelangen kann.

Bei der Auswertung der elektrischen Ausgangssignale ($S_{A1}$, $S_{A2}$, $S_{B1}$, $S_{B2}$) für die LB-Faser (23) als magnetooptischem Stromsensor muß beachtet werden, daß durch die temperaturbedingten Drehungen im Polarimeter an den Analysatoren Winkel T auftreten, die auch bei kleinen Faradaydrehungen außerhalb einer linearen Näherung liegen. Bei der Auswertung werden die gleichen Größen wie bei den Ausführungsbeispielen gemäß den Fig. 1 und 3 gebildet: Q1, Q2 und Q. Wegen der Nichtlinearitäten ist es nun erforderlich, die Stromstärke (I) durch Wurzel-, Divisions- und Arcussinus-Operationen zu berechnen. Die erforderlichen Berechnungsschritte sind nachfolgend ausgeführt: Für den mit H gekennzeichneten Hinweg und die 1. Lichtquelle (LD11) gilt:

$$S_{BA1} = I_{11} \cdot a_H \cdot D_{aH} \cdot 0{,}5 \cdot (1 + \sin (2 \cdot V \cdot I + 2 \cdot T)),$$
$$S_{BB1} = I_{11} \cdot b_H \cdot D_{bH} \cdot 0{,}5 \cdot (1 - \sin (2 \cdot V \cdot I + 2 \cdot T)).$$

Für den Hinweg und die 2. Lichtquelle (LD12) gilt:

$$S_{BA2} = I_{12} \cdot a_H \cdot D_{aH} \cdot 0{,}5 \cdot (1 + \sin (2 \cdot V \cdot I + 2 \cdot T)),$$
$$S_{BB2} = I_{12} \cdot b_H \cdot D_{bH} \cdot 0{,}5 \cdot (1 - \sin (2 \cdot V \cdot I + 2 \cdot T)).$$

Berechnet man mit diesen Gößen die Hinweg-Quotienten Q1H, Q2H und QH, so erhält man:

$$2 \cdot V \cdot I + 2 \cdot T = \arcsin [(QH^{0{,}5} - 1)/(QH^{0{,}5} + 1)].$$

Für den mit R gekennzeichneten Rückweg und die 3. Lichtquelle (LD21) gilt:

$$S_{AA1} = I_{21} \cdot a_R \cdot D_{aR} \cdot 0{,}5 \cdot (1 + \sin (2 \cdot V \cdot I - 2 \cdot T)),$$
$$S_{AB1} = I_{21} \cdot b_R \cdot D_{bR} \cdot 0{,}5 \cdot (1 - \sin (2 \cdot V \cdot I - 2 \cdot T)).$$

Für den Rückweg und die 4. Lichtquelle (LD22) gilt:

$$S_{AA2} = I_{22} \cdot a_R \cdot D_{aR} \cdot 0{,}5 \cdot (1 - \sin (2 \cdot V \cdot I - 2 \cdot T)),$$
$$S_{AB2} = I_{22} \cdot b_R \cdot D_{bR} \cdot 0{,}5 \cdot (1 + \sin (2 \cdot V \cdot I - 2 \cdot T)).$$

Berechnet man mit diesen Gößen die Rückweg-Quotienten Q1R, Q2R und QR, so erhält man:

$$2 \cdot V \cdot I - 2 \cdot T = \arcsin [(QR^{0{,}5} - 1)/(QR^{0{,}5} + 1)].$$

Daraus erhält man die Stromstärke (I) gemäß:

$$I = \{\arcsin [(QH^{0{,}5} - 1)/(QH^{0{,}5} + 1)] + \arcsin [-(QR^{0{,}5} - 1)/(Q^{0{,}5} + 1)]\}/(4 \cdot V).$$

Die Doppelindizes 11, 12, 21, 22 bei der Größe (I) beziehen sich auf die Lichtqelle, die Indizes H bzw. R bei den Größen (a, b, $D_a$, $D_b$) auf den Hin- bzw. Rückweg.

Es versteht sich, daß anstelle des Zeitmultiplexverfahrens auch hierbei das Frequenzmultiplexverfahren verwendet werden kann. Wichtig ist, daß unterschiedlich polarisiertes Licht in entgegengesetzten Richtungen durch die optische Faser (23) geleitet und separat ausgewertet wird.

Anstatt 2 Lichtquellen, wie in den Fig. 1 und 3 dargestellt, kann nur eine Lichtquelle verwendet werden, wobei die beiden Polarisationen durch einen Modulator elektrooptisch oder magnetooptisch zeitlich sequentiell erzeugt werden.

BEZEICHNUNGSLISTE

1
Lichtstrahl von LD1
2
Lichtstrahl von LD2
3
polarisierender Strahlteiler
4, 6, 11, 12
Linsen, Kollimatoren
5
hochdoppelbrechende, polarisationserhaltende optische Faser, HB-Faser
7, 7'
magnetooptische Stromsensoren, massivoptische Stromsensoren
8
Aussparung in 7
9
Stromleiter
10

polarisierender Strahlteiler, Analysator

13, 14
Multimodefasern, MMF

15
Steuer- und Auswerteinrichtung

16, 17
Frequenzgeneratoren

18 - 21
Bandpaßfilter

22
Auswerteinrichtung, Rechner, Funktionsbildner

23
magnetooptischer Stromsensor, Toroidspule aus einer niedrigdoppelbrechenden bzw. LB-Faser

24
Faserkoppler

25
Ein-/Ausgabemodul, IO-Chip

A, B
Polarisationskanäle, Polarisationsrichtungen von 10

$D_A$, $D_B$, $D_{AA}$, $D_{AB}$, $D_{BA}$, $D_{BB}$
Lichtdetektoren, Photodioden

f1, f2
Frequenzen

HB
hochdoppelbrechende Faser

i
elektrischer Strom durch 9

I
Stromstärke von i

L1, L2
polarisierte Lichtstrahlen, Eingangslichtstrahlen von 7

LB
niedrigdoppelbrechende Faser

LD, LD1, LD2, LD11, LD12, LD21, LD22
Lichtquellen, Laserdioden

MMF
Multimodefaser

P1, P2
Polarisationsrichtungen

Q, Q1, Q2
Quotienten

$S_A$, $S_B$
Ausgangssignale von $D_A$ bzw. $D_B$

$S_{A1}$, $S_{A2}$, $S_{B1}$, $S_{B2}$
Ausgangssignale von 18 - 21, 1. - 4. Lichtleistungssignale

t0 - t10
Zeitpunkte

V
Verdet-Konstante, magnetooptische Konstante

**Patentansprüche**

1. Verfahren zur magnetooptischen Strommessung

a) wobei 1. und 2. Eingangslichtstrahlen (L1, L2) in 2 rechtwinklig zueinander orientierten 1. und 2. Polarisationsrichtungen (P1, P2)

b) durch einen magnetooptischen Stromsensor (7) und

c) anschließend durch einen Analysator (10) mit 2 unter einem vorgebbaren Winkel zueinander orientierten 3. und 4. Polarisationsrichtungen (A, B) geleitet werden,

d) von welchem Analysator (10) mindestens 1. und 2. Ausgangslichtstrahlen in diesen 3. und 4. Polarisationsrichtungen (A, B) mindestens an 1. und 2. Lichtdetektoren ($D_A$, $D_B$) übertragen werden, an denen ausgangsseitig mindestens 1. und 2. Ausgangssignale ($S_A$, $S_B$; $S_{A1}$, $S_{A2}$, $S_{B1}$, $S_{B2}$) proportional zur empfangenen Lichtstärke abgreifbar sind,

e) wobei die beiden Polarisationsrichtungen (A, B) des Analysators (10) gegenüber den beiden Polarisationsrichtungen (P1, P2) der Eingangslichtstrahlen (L1, L2) in den magnetooptischen Stromsensor (7) um einen vorgebbaren Winkel gedreht sind und

f) von einem 1. Eingangslichtstrahl (L1) über den Ausgang der Lichtdetektoren ($D_A$, $D_B$) 1. und 2. Lichtleistungssignale $S_{A1}$ bzw. $S_{B1}$ oder dazu proportionale elektrische Signale sowie

g) von einem 2. Eingangslichtstrahl (L2) über den Ausgang der Lichtdetektoren ($D_A$, $D_B$) 3. und 4. Lichtleistungssignale $S_{A2}$ bzw. $S_{B2}$ oder dazu proportionale elektrische Signale abgeleitet werden,

dadurch gekennzeichnet,

h) daß die mittels des magnetooptischen Stromsensors (7) erfaßte Stromstärke I proportional zu:

$$I = \{\arcsin[(Q^{0,5} - 1)/(Q^{0,5} + 1)]\}/(2 \cdot V)$$

i) oder wenigstens annähernd proportional zu:

$$I = (Q - 1)/(8 \cdot V)$$

berechnet und ausgegeben wird, wobei $Q = S_{A1} \cdot S_{B2}/(S_{A2} \cdot S_{B1})$ und V die magnetooptische Verdet-Konstante bedeuten.

2. Verfahren zur magnetooptischen Strommessung

a) wobei 1. und 2. Eingangslichtstrahlen in 2 unter einem vorgebbaren Winkel zueinander orientierten 1. und 2. Polarisationsrichtungen (P1, P2)

b) durch einen magnetooptischen Stromsensor (23) und

c) anschließend durch einen Analysator mit 2 um einen vorgebbaren Winkel zueinander orientierten 3. und 4. Polarisationsrichtungen (A, B) geleitet werden,

d) von welchem Analysator mindestens 1. und 2. Ausgangslichtstrahlen in diesen 3. und 4. Polarisationsrichtungen (A, B) mindestens an 1. und 2. Lichtdetektoren ($D_{BA}$, $D_{BB}$) übertragen werden, an denen ausgangsseitig mindestens 1. und 2. Ausgangssignale ($S_{BA1}$, $S_{BB1}$, $S_{BA2}$, $S_{BB2}$) proportional zur empfangenen Lichtstärke abgreifbar sind,

e) wobei die beiden Polarisationsrichtungen (A, B) des Analysators gegenüber den beiden Polarisationsrichtungen (P1, P2) der Eingangslichtstrahlen in den magnetooptischen Stromsensor (23) um einen vorgebbaren Winkel gedreht sind und

f) von einem 1. Eingangslichtstrahl über den Ausgang der 1. und 2. Lichtdetektoren ($D_{BA}$, $D_{BB}$) 1. und 2. Lichtleistungssignale $S_{BA1}$ bzw. $S_{BB1}$ oder dazu proportionale elektrische Signale sowie

g) von einem 2. Eingangslichtstrahl über den Ausgang der 1. und 2. Lichtdetektoren ($D_{BA}$, $D_{BB}$) 3. und 4. Lichtleistungssignale $S_{BA2}$ bzw. $S_{BB2}$ oder dazu proportionale elektrische Signale abgeleitet werden,

dadurch gekennzeichnet,

h) daß der magnetooptische Stromsensor eine optische Faser (23) ist,

i) daß diese 1. und 2. Eingangslichtstrahlen oder 3. und 4. Eingangslichtstrahlen zusätzlich in entgegengesetzter Richtung durch diese Faser (23) geleitet werden,

j) daß von diesen 1. oder 3. Eingangslichtstrahlen über den Ausgang von 3. und 4. Lichtdetektoren ($D_{AA}$, $D_{AB}$) 5. und 6. Lichtleistungssignale $S_{AA1}$ bzw. $S_{AB1}$ oder dazu proportionale elektrische Signale sowie

k) von dem 2. oder 4. Eingangslichtstrahl über den Ausgang der 3. und 4. Lichtdetektoren ($D_{AA}$, $D_{AB}$) 7. und 8. Lichtleistungssignale $S_{AA2}$ bzw. $S_{AB2}$ oder dazu proportionale elektrische Signale abgeleitet werden und

l) daß die mittels des magnetooptischen Stromsensors (23) erfaßte Stromstärke I wenigstens annähernd proportional zu:

$$I = \{\text{arc sin} \,[(QH^{0,5} - 1)/(QH^{0,5} + 1)] + \text{arc sin} \,[(QR^{0,5} - 1)/(QR^{0,5} + 1)]\}/(4 \cdot V)$$

berechnet und ausgegeben wird, wobei

$$QH = S_{BA1} \cdot S_{BB2}/(S_{BA2} \cdot S_{BB1}),$$
$$QR = S_{AA1} \cdot S_{AB2}/(S_{AA2} \cdot S_{AB1}) \text{ und}$$

V die magnetooptische Verdet-Konstante bedeuten.

3. Verfahren nach Anspruch 1 oder 2, dadurch gekennzeichnet, daß die Eingangslichtstrahlen (L1, L2) gleiche Wellenlänge aufweisen.

4. Verfahren nach einem der Ansprüche 1 bis 3, dadurch gekennzeichnet, daß unterschiedlich polarisierte 1. und 2. oder 3. und 4. Eingangslichtstrahlen (L1, L2) in zeitlicher Aufeinanderfolge alternierend durch den magnetooptischen Stromsensor (7, 23) geleitet werden.

5. Verfahren nach einem der Ansprüche 1 bis 3, dadurch gekennzeichnet,

a) daß unterschiedlich polarisierte 1. und 2. Eingangslichtstrahlen (L1, L2) mit 2 verschiedenen Frequenzen (f1, f2) in ihrer Intensität moduliert werden und

b) daß die Ausgangssignale ($S_A$, $S_B$) der Lichtdetektoren ($D_A$, $D_B$) jeweils einer Bandpaßfilterung mit diesen beiden Frequenzen (f1, f2) unterzogen werden, zur Gewinnung der Lichtleistungssignale ($S_{A1}$ - $S_{B2}$) oder der dazu proportionalen elektrischen Signale.

6. Magnetooptische Strommeßeinrichtung

a) mit mindestens einer Lichtquelle (LD1, LD2),

b) ferner mit einem magnetooptischen Stromsensor (7) und

c) einem 1. polarisierenden Strahlteiler (3) im Strahlengang zwischen dieser mindestens einen Lichtquelle (LD1, LD2) und dem magnetooptischen Stromsensor (7), welcher 1. Strahlteiler (3) mindesten 1. und 2. Eingangslichtstrahlen (L1, L2) für den magnetooptischen Stromsensor (7) in 2 um einen vorgebbaren Winkel zueinander orientierten 1. und 2. Polarisationsrichtungen (P1, P2) erzeugt,

d) mit mindestens 1. und 2. Lichtdetektoren ($D_A$, $D_B$), an denen ausgangsseitig mindestens 1. und 2. Ausgangssignale ($S_A$, $S_B$) proportional zur empfangenen Lichtstärke abgreifbar sind,

e) mit einem 2. polarisierenden Strahlteiler (10) im Strahlengang zwischen diesem magnetooptischen Stromsensor (7) und diesen mindestens 2 Lichtdetektoren ($D_A$, $D_B$), welcher Strahlteiler (10) 2 um einen vorgebbaren Winkel zueinander orientierte 3. und 4. Polarisationsrichtungen (A, B) aufweist, die gegenüber den beiden Polarisationsrichtungen (P1, P2) des 1. Strahlteilers (3) um einen vorgebbaren Winkel gedreht sind, und

f) mit einer Steuer- und Auswerteinrichtung (15) zur Steuerung dieser mindestens einen Lichtquelle (LD1, LD2) und zur Auswertung der Ausgangssignale ($S_A$, $S_B$; SA1, SA2, SB1, SB2) dieser beiden Lichtdetektoren ($D_A$, $D_B$),

g) wobei diese Steuer- und Auswerteinrichtung (15) einen Diskriminator aufweist, der von einem 1. Eingangslichtstrahl (L1) über den Ausgang der Lichtdetektoren ($D_A$, $D_B$) 1. und 2. Lichtleistungssignale $S_{A1}$ bzw. $S_{B1}$ oder dazu proportionale elektrische Signale sowie

h) von einem 2. Eingangslichtstrahl (L2) über den Ausgang der Lichtdetektoren ($D_A$, $D_B$) 3. und 4. Lichtleistungssignale $S_{A2}$ bzw. $S_{B2}$ oder dazu proportionale elektrische Signale ableitet,

dadurch gekennzeichnet,

i) daß die Steuer- und Auswerteinrichtung (15) einen Funktionsbildner (22) aufweist, welcher eine mittels des magnetooptischen Stromsensors (7) erfaßte Stromstärke I proportional zu:

$$I = \{arc\ sin\ [(Q^{0,5} - 1)/(Q^{0,5} + 1)]\}/(2 \cdot V)$$

j) oder wenigstens annähernd proportional zu:

$$I = (Q - 1)/(8 \cdot V)$$

berechnet und ausgibt, wobei $Q = S_{A1} \cdot S_{B2}/(S_{A2} \cdot S_{B1})$ und V die magnetooptische Verdet-Konstante bedeuten.

7. Magnetooptische Strommeßeinrichtung

a) mit mindestens einer Lichtquelle (LD; LD1, LD2; LD11, LD12, LD21, LD22),

b) ferner mit einem magnetooptischen Stromsensor (23) und

c) einem 1. polarisierenden Strahlteiler im Strahlengang zwischen dieser mindestens einen Lichtquelle (LD; LD1, LD2; LD11, LD12, LD21, LD22) und dem magnetooptischen Stromsensor (23), welcher 1. Strahlteiler mindestens 1. und 2. Eingangslichtstrahlen für den magnetooptischen Stromsensor (23) in 2 um einen vorgebbaren Winkel zueinander orientierten 1. und 2. Polarisationsrichtungen (P1, P2) erzeugt,

d) mit mindestens 1. und 2. Lichtdetektoren ($D_{AA}$, $D_{AB}$), an denen ausgangsseitig mindestens 1. und 2. Ausgangssignale ($S_A$, $S_B$) proportional zur empfangenen Lichtstärke abgreifbar sind,

e) mit einem 2. polarisierenden Strahlteiler (10) im Strahlengang zwischen diesem magnetooptischen Stromsensor (7) und diesen mindestens 2 Lichtdetektoren ($D_A$, $D_B$), welcher Strahlteiler (10) 2 um einen vorgebbaren Winkel zueinander orientierte 3. und 4. Polarisationsrichtungen (A, B) aufweist, die gegenüber den beiden Polarisationsrichtungen (P1, P2) des 1. Strahlteilers (3) um einen vorgebbaren Winkel gedreht sind, und

f) mit einer Steuer- und Auswerteinrichtung (15) zur Steuerung dieser mindestens einen Lichtquelle (LD1, LD2) und zur Auswertung der Ausgangssignale ($S_{BA1}$, $S_{BB1}$, $S_{BA2}$, $S_{BB2}$) dieser beiden Lichtdetektoren ($D_{BA}$, $D_{BB}$),

g) wobei diese Steuer- und Auswerteinrichtung (15) einen Diskriminator aufweist, der von einem 1. Eingangslichtstrahl über den Ausgang der Lichtdetektoren ($D_{BA}$, $D_{BB}$) 1. und 2. Lichtleistungssignale $S_{BA1}$ bzw. $S_{BB1}$ oder dazu proportionale elektrische Signale sowie

h) von einem 2. Eingangslichtstrahl über den Ausgang der Lichtdetektoren ($D_{BA}$, $D_{BB}$) 3. und 4. Lichtleistungssignale $S_{BA2}$ bzw. $S_{BB2}$ oder dazu proportionale elektrische Signale ableitet,

dadurch gekennzeichnet,

i) daß der magnetooptische Stromsensor eine optische Faser (23) ist,

j) daß ein Ein-/Ausgabemodul (25) vorgesehen ist, um diese 1. und 2. Eingangslichtstrahlen oder 3. und 4. Eingangslichtstrahlen zusätzlich in entgegengesetzter Richtung durch diese Faser (23) zu leiten,

k) daß von diesen 1. oder 3. Eingangslichtstrahlen über den Ausgang von 3. und 4. Lichtdetektoren ($D_{AA}$, $D_{AB}$) 5. und 6. Lichtleistungssignale $S_{AA1}$ bzw. $S_{AB1}$ oder dazu proportionale elektrische Signale sowie

l) von dem 2. oder 4. Eingangslichtstrahl über den Ausgang der 3. und 4. Lichtdetektoren ($D_{AA}$, $D_{AB}$) 7. und 8. Lichtleistungssignale $S_{AA2}$ bzw. $S_{AB2}$ oder dazu proportionale elektrische Signale abgreifbar sind und

m) daß die Steuer- und Auswerteinrichtung (15) einen Funktionsbildner (22) aufweist, welcher die mittels des magnetooptischen Stromsensors (23) erfaßte Stromstärke I wenigstens annähernd proportional zu:

$$I = \{arc\ sin\ [(QH^{0,5} - 1)/(QH^{0,5} + 1)] + arc\ sin\ [(QR^{0,5} - 1)/(QR^{0,5} + 1)]\}/(4 \cdot V)$$

berechnet und ausgibt, wobei $QH = S_{BA1} \cdot S_{BB2}/(S_{BA2} \cdot S_{BB1})$, $QR = S_{AA1} \cdot S_{AB2}/S_{AA2} \cdot S_{AB1})$ und

V die magnetooptische Verdet-Konstante bedeuten.

8. Magnetooptische Strommeßeinrichtung nach Anspruch 7, dadurch gekennzeichnet, daß das Ein-/Ausgabemodul (25) über hochdoppelbrechende, polarisationserhaltende HB-Fasern mit einem magnetooptischen Stromsensor aus einer niedrigdoppelbrechenden LB-Faser (23) verbunden ist.

9. Magnetooptische Strommeßeinrichtung nach einem der Ansprüche 6 bis 8, dadurch gekennzeichnet, daß der 1. und 2. polarisierende Strahlteiler (3, 10) jeweils senkrecht zueinander orientierte Polarisationsrichtungen (P1, P2; A, B) aufweisen.

10. Magnetooptische Strommeßeinrichtung nach einem der Ansprüche 6 bis 9, dadurch gekennzeichnet, daß die 3. und 4. Polarisationsrichtungen (A, B) des 2. Strahlteilers (10) gegenüber den 1. und 2. Polarisationsrichtungen (P1, P2) des 1. Strahlteilers (3) um 45° gedreht sind.

Fig.1

Fig.2a

Fig.2b

Fig.2c

Fig.2d

Fig.3

Fig.4

11

Fig.5

Fig.6